# EUROPEAN PATENT APPLICATION

(11) **EP 1 351 289 A1**
(43) Date of publication of application: **08.10.2003**
(21) Application number: 03007398.5
(22) Date of filing: 02.04.2003
(51) Int. Cl.: H01L 21/768, H01L 21/288

(54) **Method and apparatus for forming fine circuit interconnects**

(30) Priority: 02.04.2002 JP 2002099970
(71) Applicant: EBARA CORPORATION, Ohta-ku, Tokyo (JP); NEC Electronics Corporation, Kawasaki, Kanagawa 211-8668 (JP)
(72) Inventor: Ito, Nobukazu, Nakahara-ku, Kawasaki, Kanagawa (JP); Hongo, Akihisa, Yokohama-shi, Kanagawa-ken (JP); Fukunaga, Akira, Chigasaki-shi, Kanagawa-ken (JP); Nagai, Mizuki, Fujisawa-shi, Kanagawa-ken (JP); Kimizuka, Ryoichi, Tokyo (JP); Kobayashi, Takeshi, Fujisawa-shi, Kanagawa-ken (JP); Sato, Takuro, Sagamihara-shi, Kanagawa-ken (JP)
(74) Representative: Wagner, Karl H., Dipl.-Ing.

(57) **Abstract**

There is provided a method and apparatus for forming fine circuit interconnects that can form, by copper plating, copper interconnects in which movement of copper atoms is retarded or suppressed whereby electromigration is prevented. The method for forming fine circuit interconnects, comprising, providing a substrate for electronic circuit having fine circuit patterns which are covered with a barrier layer (4) and optionally a seed layer (5), forming a first plated film (6) on the surface of the substrate by copper alloy plating, and forming a second plated film (7) on the surface of the first plated film by copper plating.

## Description

### BACKGROUND OF THE INVENTION

### Field of the Invention:

The present invention relates to a method and an apparatus for forming fine circuit interconnects by plating on the surface of a substrate having fine circuit patterns, such as a semiconductor wafer or a printed wiring board, and more particularly to a method and an apparatus for forming fine circuit interconnects which employs alloy plating to provide fine circuit interconnects without stress-migration and electromigration.

### Description of the Related Art:

For the formation of interconnects in a substrate having fine circuit patterns, such as a semiconductor wafer or a printed wiring board, aluminum has conventionally been used as a primary interconnect material. In response to the recent trend toward finer circuit patterns, copper with lower electrical resistance than aluminum has also become used as an interconnect material. Such copper interconnects are currently producedmainly by plating using copper sulfate plating solution.

In recent years, there is an increasing demand for finer circuits on a substrate. This requires smaller interconnect spaces and thinner interconnect layers and, in addition, leads to a severe requirement for enhanced endurance to migration. There are known two types of migration, one of which is called "electromigration". Electromigration is such a phenomenon that metal atoms forming interconnects are moved locally due to an electric current of high density, finally leading to disconnection. The other one is called "stress-migration", which is such a phenomenon that metal atoms forming interconnects are moved due to stress in the interconnects. It is becoming difficult with the conventional aluminum interconnect technology or pure copper interconnect technology to cope with these migrations.

In order to cope with the migration phenomena, many studies have been made concerning the optimization of a cap material (protective film) for selectively covering and protecting a copper film after chemical mechanical polishing (CMP), of a barrier metal to be first applied to a substrate, and of a seed metal to be applied onto a barrier layer. However, a sufficient solution to the migration problem has not been provided yet.

### SUMMARY OF THE INVENTION

The present invention has been made in view of the above situation in the related art. It is therefore an object of the present invention to provide a method and an apparatus for forming fine circuit interconnects that can form, by copper plating, copper interconnects in which movement of copper atoms is retarded or suppressed whereby the migration is prevented.

It has now been found by the present inventors that the movement velocity of copper atoms is lower in a copper alloy than in pure copper. It has also been found that forming a plated film of a copper alloy, in advance of copper plating for the formation of electronic circuit, can remarkably suppress the migration in the fine interconnects. The present invention has been accomplished based on these findings.

Thus, the present invention provides a method for forming fine circuit interconnects, comprising: providing a substrate for electronic circuit having fine circuit patterns which are covered with a barrier layer and optionally a seed layer; forming a first plated film on the surface of the substrate by copper alloy plating; and forming a second plated film on the surface of the first plated film by copper plating.

In the case of pure copper interconnects , obtained by copper plating, atomic migration due to an electric current of high density frequently occurs. Further, the interconnects are easy to deform by stress, and are poor in electromigration resistance and stress-migration resistance.

According to the above method of the present invention, a copper alloy plated film (first plated film) is formed in advance of copper plating, and an annealing treatment may be carried out after copper plating so as to alloy the overall interconnects, whereby the migration of copper atoms and the deformation of interconnects can be suppressed.

The reason for the effect of enhancing migration endurance according to the present invention is not fully clarified yet. However, it may be considered to be due to suppression of movement of copper atoms in copper interconnects and also to be improved deformation resistance of the copper interconnects, both ascribable to the alloying of copper.

The first plated film formed by plating with a copper alloy is preferably one that prevents electromigration and/or stress-migration of copper.

The first plated film is deposited from an alloy plating solution containing copper and a metal which can form a eutectoid alloy with copper. Specific examples of the metal which can form a eutectoid alloy with copper include Fe, Co. Ni, Zn, Sn, In, Ga, Tl, Zr, W, Mo, Rh, Ru, Ir, Ag, Au, and Bi.

The content of the metal other than copper in the first plated film formed by copper alloy plating is preferably 0.01 to 10 atomic %. The resistivity of the first plated film formed by copper alloy plating is preferably not more than 5 µΩ · cm in terms of volume resistivity.

The first plated film may be formed by electroplating or electroless plating preferably with a thickness of 1 nm to 200 nm.

The second plated film formed by copper plating may be one for embedding of fine trenches and/or via holes provided in the substrate. The second plated film may be formed, for example, in a copper plating bath containing sulfuric acid, or an alkane or alkanol sulfonic acid, or in a copper plating bath containing pyrophosphoric acid.

After the formation of the second plated film by copper plating, it is preferred to carry out an annealing treatment at 100 to 500 °C.

The present invention also provides an apparatus for forming fine circuit interconnects, comprising: a copper alloy plating section for forming a first plated film on the surface of a substrate by copper alloy plating; a copper plating section for forming a second plated film on the surface of the first plated film by copper plating; a cleaning section for cleaning the substrate; and a carry-in and carry-out section for carrying in and out the substrate.

The above and other objects, features, and advantages of the present invention will be apparent from the following description when taken in conjunction with the accompanying drawings which illustrates preferred embodiments of the present invention by way of example.

### BRIEF DESCRIPTION OF THE DRAWINGS

FIGS. 1A through 1E are cross-sectional views showing, in sequence of process steps, a method for forming fine circuit interconnects according to an embodiment of the present invention;
FIG. 2 is a layout plan of an apparatus for forming fine circuit interconnects according to an embodiment of the present invention;
FIG. 3 is a layout plan of an apparatus for forming fine circuit interconnects according to another embodiment of the present invention;
FIG. 4 is a layout plan of an apparatus for forming fine circuit interconnects according to still another embodiment of the present invention;
FIG. 5 is a layout plan of an apparatus for forming fine circuit interconnects according to still another embodiment of the present invention; and
FIG. 6 is a layout plan of an apparatus for forming fine circuit interconnects according to still another embodiment of the present invention, in which polishing sections are incorporated.

### DETAILED DESCRIPTION OF THE PREFERRED EMBODIMENTS

Preferred embodiments of the present invention will now be described with reference to the drawings.

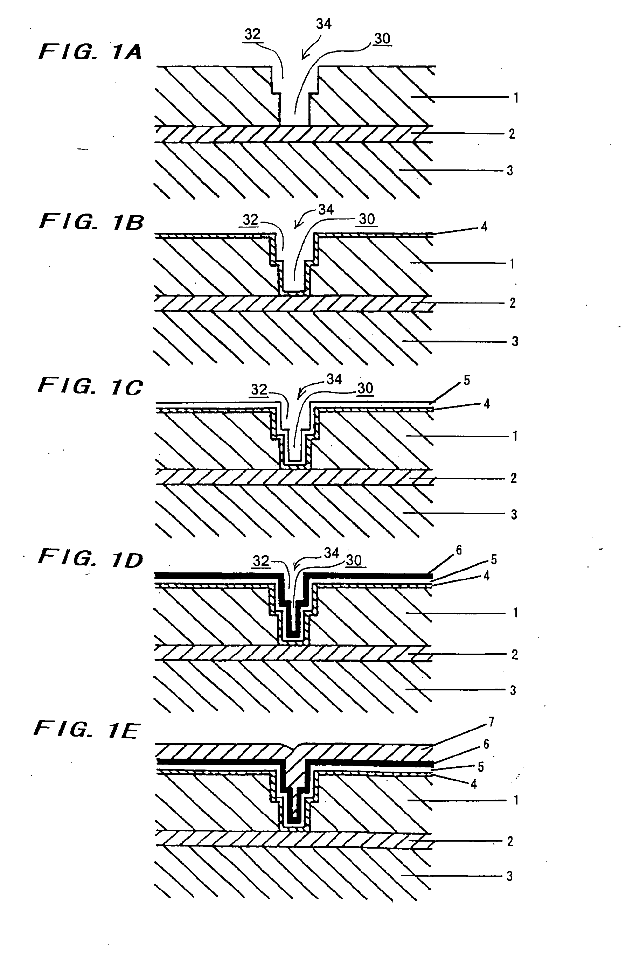

FIGS. 1A through 1E are cross-sectional views showing, in sequence of process steps, a method for forming fine circuit interconnects according to an embodiment of the present invention. First, as shown in FIG. 1A, fine circuit patterns 34, comprising via holes 30 and fine trenches 32, are formed e.g. by a lithography/etching technique in an insulating layer 1 deposited on the surface of a conductive layer 2 formed on the surface of a substrate 3. Next, as shown in FIG. 1B, a barrier layer 4 is formed over the surface of the substrate having the thus-formed circuit patterns 34. Thereafter, as shown in FIG. 1C, a seed layer or a catalyst layer 5 is formed on the barrier layer 4. Thereafter, as shown in FIG. 1D, a first plated film 6 of a copper alloy is formed on the surface of the seed layer or the catalyst layer 5 and, as shown in FIG. 1E, a second plated film 7 composed of copper is formed on the surface of the first plated film 6, thereby filling the circuit patterns 34 comprising of the via holes 30 and the fine trenches 32 with copper.

The substrate 3 is, for example, a semiconductor substrate or a printed circuit board on which fine circuit interconnects are to be formed. The circuit patterns 34 on the substrate 3 comprises, for example, via holes 30 and fine trenches 32 which, when filled with metal copper, become circuit interconnects.

The substrate 3 is pretreated in the usual manner before it is subj ected to the fine circuit interconnects-forming process according to the present invention. In the case of a silicon substrate such as a silicon wafer, for example, the barrier layer 4 of Ta, TaN, TiN, WN, TiSiN, Co-W-P, Co-W-B, or the like is formed as a pretreatment on the surface of the substrate 3, as shown in FIG. 1B. Further, in the case of later forming the first plated film by electroplating, the copper seed layer 5, which will serve as an electric supply layer, is formed by e.g. PVD as a pretreatment after the formation of barrier layer 4, as shown in FIG. 1C. In the case of later forming the first layer by electroless plating, on the other hand, the catalyst layer 5 is formed as a pretreatment.

On the surface of the thus-pretreated substrate 3, as shown in FIG. 1D, the first plated film 6 is formed by copper alloy plating. The plating is carried out in such a manner that the plated film thinly covers the entire surface of the via holes 30 and fine trenches 32 comprising the fine circuit patterns 34.

The alloy film (first plated film 6) is formed by the first plating carried out in a copper alloy plating bath containing a combination of copper and other metal (s). Any metal other than copper may be used in the plating bath insofar as it can co-deposit with copper and form a eutectoid alloy film. Specific examples of such metals include Fe, Co, Ni, Zn, Sn, In, Ga, Tl, Zr, W, Mo, Rh, Ru, Ir, Ag, Au, and Bi.

The plating for forming the copper alloy film may be electroplating or electroless plating. In either case, it is preferred to use a plating bath containing the metal other than copper (hereinafter referred to as "eutectoid metal") in such an amount that its content in the copper alloy plated film becomes about 0.01 to 10 atomic %. If the content of the eutectoid metal in the plated film is less than 0.01 atomic %, the plated film has little'effect of improving migration resistance. If the content of the eutectoid metal exceeds 10 atomic %, on the other hand, though a good migration resistance may be obtained, the resistivity of the plated film forming interconnects or circuits will increase, whereby the merit of low resistivity, inherent in copper, will be lost.

In the formation of fine circuits, to which the present invention is directed, a high resistance of interconnect circuits formed by plating may cause the problems of heat generation and signal transmission delay. It is therefore preferred that the alloy film (first plated film 6) formed by the first plating have a volume resistivity of not more than 5 µΩ·cm, especially not more than 3 µΩ·cm.

The copper alloy plating bath for forming the copper alloy film is per se known. In carrying out the method of the present invention, an appropriate bath may be selected among various known copper alloy plating baths, taking the type of deposited metal, the deposition ratio, the resistivity of deposited layer, the plating conditions, the facility of carrying out plating, etc. into consideration.

For example, when using Fe, Co, Ni, Zn, Sn, Ti, etc. as a eutectoid metal, a copper alloy plating bath may be prepared according to references, for example, Enomoto et al., "Alloy plating", The Nikkan Kogyo Shimbun, Ltd., 1987, and 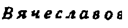 ,"New alloy plating method" , Nisso Tsushin-sha, 1980. In the "Alloy plating", copper-zinc alloy plating, copper-nickel alloy plating, and copper-tin alloy plating are described on pages 35-47, 78-87, and 139-140, respectively. In the "New alloy plating method", copper-zinc alloy plating, copper-tin alloy plating, copper-nickel alloy plating, and copper-indium alloy plating are described on pages 39-42, 42-51, 52-54, and 54, respectively. Further, when using In or Zr as a eutectoid metal, reference may be made to 2nd Lecture (CD-ROM) of Session No. 4 at IITC Proceedings 2001.

The copper concentration of the copper alloy plating bath is preferably about 1 to 50 g/L, especially 2.5 to 10 g/L. The amount of a eutectoid metal in the copper alloy plating bath varies depending upon the kind of the metal. For instance, when the eutectoid metal is Fe, Co, Ni, Rh, Ru or Ir, it is preferably used in an amount of about 0.1 to 50 g/L, especially 5-25 g/L. When the eutectoid metal is Zn or Sn, it is preferably used in an amount of about 0.01 to 10 g/L, especially 0.05 to 0.5 g/L. In the case of In, Ga, Tl or Zr, the eutectoid metal is preferably used in an amount of about 0.5 to 50 g/L, especially 2.5 to 25 g/L.

In order to deposit a copper alloy film from a plating bath containing copper and a eutectoidmetal, it is necessary to control the deposition potential so as to bring the deposition potential of copper closer to that of the eutectoidmetal. For this purpose, an optimum complexing agent for the particular combination of copper and the eutectoid metal must be selected. The amount of such a complexing agent depends on the metal species and the amounts of metals used, the stability constants of the metals, etc. The pH and temperature of the plating bath, and the current density can be important factors in controlling the eutectoid ratio. Further, if necessary, an organic additive, such as a deposition inhibitor or a deposition promoter, may be added to the plating bath.

A variety of complexing agents may be used in the copper alloy plating bath . Among others, organic acids such as aliphatic carboxylic acids, organic amines and metaphosphates are preferred. Specific examples of such complexing agents include ethylenediaminetetraacetic acid, ethylenediamine, N, N', N", N'"-ethylenedinitrotetrapropane-2-ol, pyrophosphoric acid, iminodiacetic acid, diethylenetriamine, triethylenetetramine, tetraethylenepentamine, diamino butane, hydroxyethyl ethylenediamine, ethylenediamine tetrapropionic acid, ethylenediamine tetramethylene phosphonic acid, diethylenetriamine tetramethylene phosphonic acid and their derivatives, and their salts.

The type of a suitable complexing agent and its appropriate concentration in the plating bath vary depending upon the eutectoid metal species used and its amount, the plating bath pH, the current density in plating, the plating bath temperature, etc., and therefore are not strictly limited. However, it is generally preferred to use a complexing agent in an amount which is at least 1.5 times and less than 30 times the minimum amount necessary for complexing copper and eutectoid metal ions in a copper alloy plating solution.

When the amount of complexing agent is less than 1.5 times the minimum amount for complexing, the plating bath itself and the quality and alloy ratio of the deposited plated film are likely to be unstable. When the amount of complexing agent is more than 30 times the minimum amount, on the other hand, though the plating bath is stable, the deposition efficiency will decrease to significantly lower the film-forming rate. Furthermore, disposability of a waste liquid, such as cleaning water, will be lowered, which is undesirable from an environmental viewpoint.

Especially preferred complexing agents and their preferred amounts to be used are as follows:
Pyrophosphoric acid: 50-150 g/L
Glycine: 25-100 g/L
Ethylenediamine: 20-100 g/L
NTA: 50-150 g/L

The first plating described above is carried out until the thickness of the copper alloy plated film (first plated film 6) becomes about 1 to 200 nm, preferably about 5 to 50 nm, that is, the plated film comes to thinly cover the entire surface of the via holes 30 and fine trenches 32 comprising the fine circuit patterns 34. The conditions for forming the first plated film 6 with such a thickness vary depending upon the type of the copper alloy plating bath used and other factors, and the optimum conditions for a particular plating bath should be determined individually. More specifically, the basic conditions differ significantly depending upon whether the plating is electroplating or electroless plating. In addition, the plating conditions, such as the plating bath temperature, the plating time, with or without stirring, with or without electrolysis and the current density, vary depending also on the type of the eutectoid metal used. Accordingly, optimum conditions must be determined experimentally.

The following are examples of the compositions of plating baths and-the plating conditions for electroplating and for electroless plating, which are preferably used in the first plating according to the present invention:

| (Electroplating) | |
|---|---|
| <Bath composition> | |
| Copper pyrophosphate | 5 - 25 g/L |
| Tin pyrophosphate | 0.01 - 10 g/L |
| Pyrophosphoric acid | 75 - 150 g/L |
| PH | 8.5 - 11.5 (adjusted with TMAH) |

| <Plating conditions> | |
|---|---|
| Current density | 0.25 - 1 A/dm² |
| Plating time | 10 - 40 sec |
| Temperature | 15 - 40 °C |

| (Electroless plating) | |
|---|---|
| <Bath composition> | |
| Copper sulfate | 5 - 25 g/L |
| Tin sulfate | 0.01 - 10 g/L |
| EDTA | 15 - 100 g/L |
| Glyoxylic acid | 5 - 60 g/L |
| pH | 9.0 - 13.5 (adjusted with TMAH) |

| <Plating conditions> | |
|---|---|
| Plating time | 10 - 150 sec |
| Temperature | 20 - 80 °C |

As described above, after the formation of the first plated film 6 on the substrate 3, the second plated film 7 is formed on the first plated film 6 by copper plating as shown in FIG. 1E.

The copper plated film (second plated film) 7 can be formed by acidic copper plating or alkaline copper plating that has been conventionally employed for copper plating of a substrate having fine circuit patterns. Thus, the second plating can be carried out by using a copper plating bath containing sulfuric acid, or alkane or alkanol sulfonic acid, or a copper plating bath containing pyrophosphoric acid.

The copper plating bath compositions and plating conditions that have been conventionally employed for embedding of fine circuit patterns (trenches and holes) in a substrate can be utilized, as they are, in the second plating according to the present invention. Thus, for example, a copper plating bath of a composition with a low anion concentration, e.g. sulfuric acid, and having excellent leveling properties, may be used.

The following are examples of the composition of acidic copper plating bath and of the plating conditions, which are preferably used in the second plating according to the present invention:

| (Electroplating) | |
|---|---|
| <Bath composition> | |
| Copper sulfate | 150 - 250 g/L |
| Sulfuric acid | 10 - 100 g/L |
| Chlorine | 30 - 90 mg/L |
| Organic additive | 1 - 20 mL/L |

| <Plating conditions> | |
|---|---|
| Current density | 0.3 - 5 A/dm² |
| Plating time | 30 sec - 5 min |
| Temperature | 20 - 30 °C |

The substrate 3, having the fine circuit patterns 34 which have been-filled with the second plated film 7 formed by the above-described copper plating, is annealed and then subjected to CMP processing to remove unnecessary plated copper portions, thereby forming fine circuit interconnects of copper on the substrate 3 . Though the copper sulfate plating bath, the typical acidic copper plating bath, has been specifically shown above, it is of course possible to use an alkaline copper plating bath, such a copper pyrophosphate plating bath.

Annealing has been carried out for crystal growth of copper also in the conventional formation of fine circuit interconnects by copper plating. According to the present invention, annealing is carried out not only for crystal growth of copper, but also for promoting diffusion of a eutectoid metal, and is effective for enhancing migration endurance. The annealing is carried out by keeping the substrate after copper plating at a temperature of about 100 to 500 °C, preferably about 300 to 400 °C.

As an apparatus for effectively carrying out the above-described method of the present invention, use may be made of a fine circuit interconnects-forming apparatus comprising a copper alloy plating device for forming a first plated film on an electronic circuit substrate, a copper plating device for forming a second plated film on the first plated film, a water-cleaning device for water-cleaning the substrate, and a device for carrying in and out the substrate.

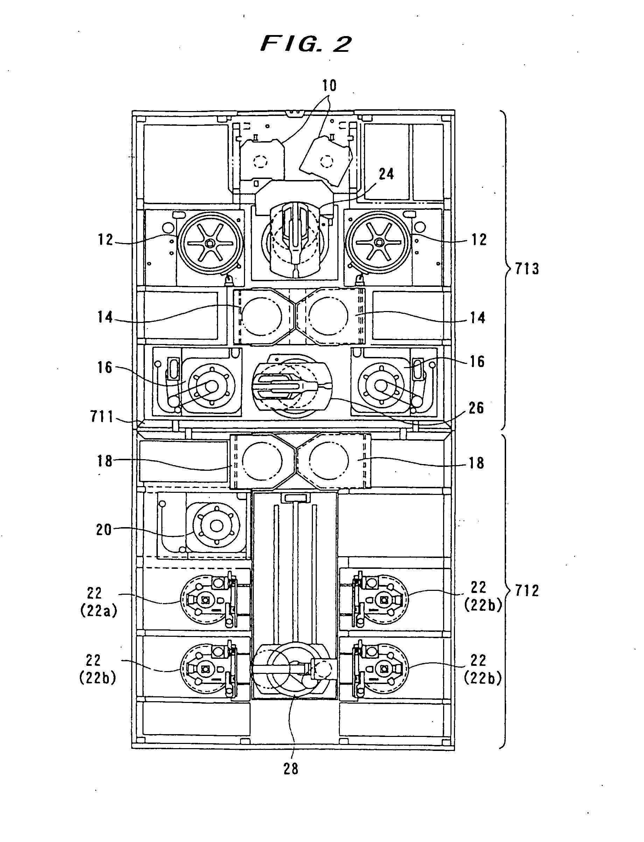

FIG. 2 is a plan view of an embodiment of such a fine circuit interconnects-forming apparatus. The apparatus includes loading/unloading sections 10, each pair of cleaning/drying sections 12, first substrate stages 14, bevel-etching/chemical cleaning -sections 16 and second substrate stages 18, a water-washing section 20 having a function of 180°-reversing a substrate, and plating sections 22. The plating sections 22 includes one copper alloy plating bath 22a for forming the first plated film 6 shown in FIG. 1D and three copper plating baths 22b for forming the second plated film 7 shown in FIG. 1E.

The apparatus is also provided with a first transfer mechanism 24 for transferring a substrate between the loading/unloading sections 10, the cleaning/drying sections 12 and the first substrate stages 14, a second transfer mechanism 26 for transferring the substrate between the first substrate stages 14, the bevel-etching/chemical cleaning sections 16 and the second substrate stages 18, and a third transfer mechanism 28 for transferring the substrate between the second substrate stages 18, the water-washing section 20 and the plating sections 22.

The interior of the fine circuit interconnects-forming apparatus is partitioned by a partition wall 711 into a plating space 712 and a clean space 713. The plating space 712 and the clean space 713 are so designed that supply and discharge of air can be made independently. The partition wall 711 is provided with an openable shutter (not shown) . Further, the pressure in the clean space 713 is kept lower than atmospheric pressure and higher than the pressure in the plating space 712, so that air in the clean space 713 is prevented from flowing out of the fine circuit interconnects-forming apparatus and air in the plating space 712 is prevented from flowing into the clean space 713.

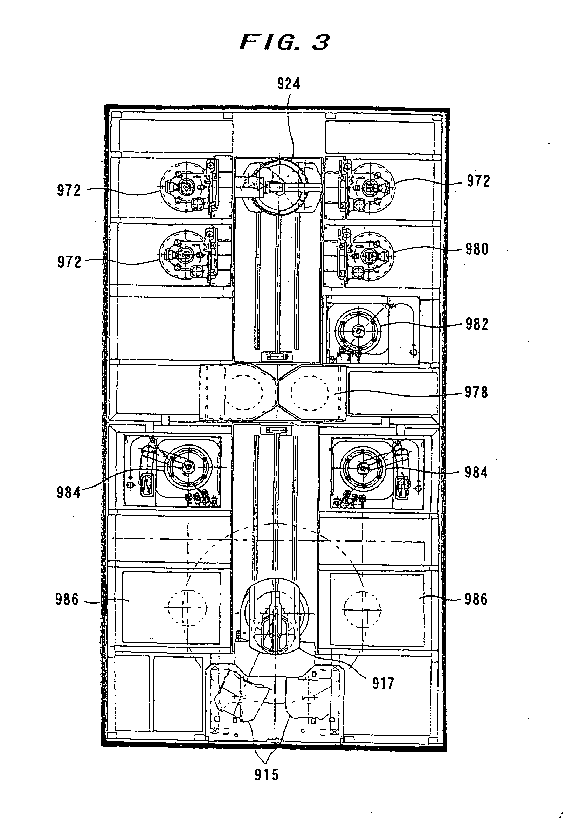

FIG. 3 is a plan view of an apparatus for forming fine circuit interconnects according to another embodiment of the present invention. The apparatus includes loading/unloading sections 915, each pair of annealing sections 986, bevel-etching/chemical cleaning sections 984 and substrate stages 978, a water-washing section 982 having a function of 180°-reversing a substrate, one first plating section 980 for carrying out a first-step plating (copper alloy plating), and three second plating sections 972 each for carrying out a second-step plating (filling with copper by copper plating).

The apparatus is also provided with a movable first transfer mechanism 917 for transferring a substrate between the loading/unloading sections 915, the annealing sections 986, the bevel-etching/chemical cleaning sections 964 and the substrate stages 978, and a movable second transfer mechanism 924 for transferring the substrate between the substrate stages 978, the water-washing section 982, the first plating section 980 and the second plating sections 972.

According to the apparatus of this embodiment, a substrate formed the seed layer 5 thereon, as shown in FIG. 1C, is first taken one-by-one by the first transfer mechanism 917 out of the loading/unloading sections 915, and is carried in the first plating section 980 via the substrate stage 978.

Next, first-step copper alloy plating is carried out to the surface of the substrate in the first plating section 980. After the plating, as necessary, the substrate is transferred to the water-washing section 982 to water-wash the substrate. The substrate is then transferred to one of the second plating sections 972.

In the second plating section 972, second-step plating of the surface of the substrate is carried out by using a second plating solution, thereby filling the circuit patterns with copper. The formation of the first plated film 6 (see FIG. 1D) by the first-step plating can prevent occurrence of migration between the second plated film (copper film layer) 7 and the seed layer 5, enabling embedding of copper without voids and disconnections .

After completion of the second-step plating, as necessary, the substrate is transferred to the water-washing section 982 to water-wash the substrate. The substrate is then transferred to one of the bevel-etching/chemical cleaning sections 984. In the bevel-etching/chemical cleaning section 984, the substrate after copper plating is cleaned with a chemical liquid and, at the same time, the thin copper film, etc. formed in the bevel portion of the substrate is etched away. Further, after rinsing the substrate with pure water, the substrate is spin-dried by rotating the substrate at a high speed. Thereafter, the dried substrate is transferred to one of the annealing sections 986, where the substrate is annealed. After the annealing, the substrate is returned by the first transfer mechanism 917 to a cassette in the loading/unloading sections 915.

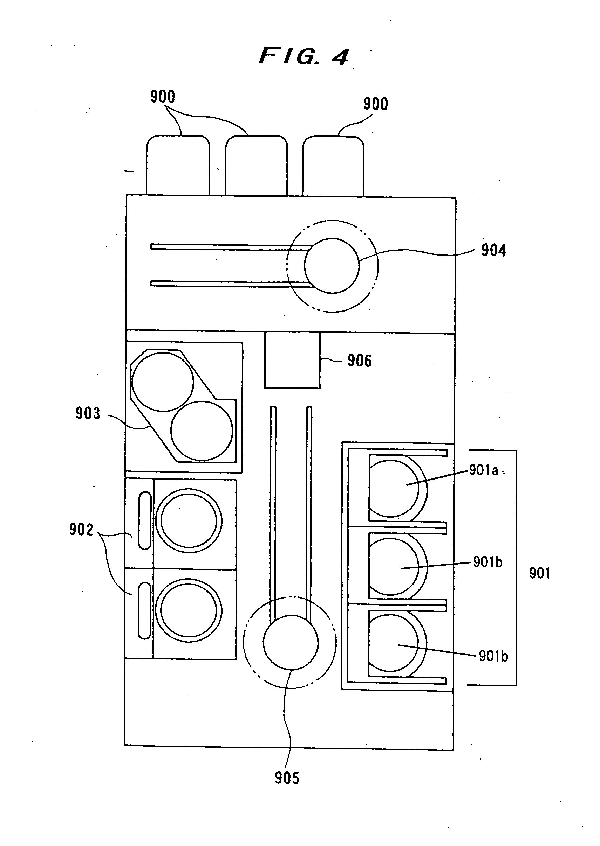

FIG. 4 is a layout plan of an apparatus for forming fine circuit interconnects according to still another embodiment of the present invention. The apparatus includes loading/unloading sections 900, an annealing section 903, two bevel-etching/chemical cleaning sections 902, a substrate stage 906, and three plating sections 901. The plating sections 901 include one copper alloy plating bath 901a for forming the first plated film 6 (see FIG. 1D) and two copper plating baths 901b for forming the second plated film 7 (see FIG. 1E).

The apparatus is also provided with a movable first transfer mechanism 904 for transferring a substrate between the loading/unloading sections 900 and the substrate stage 906, and a movable second transfer mechanism 905 for transferring the substrate between the substrate stage 906, the annealing section 903, the bevel-etching/chemical cleaning sections 902 and the plating sections 901.

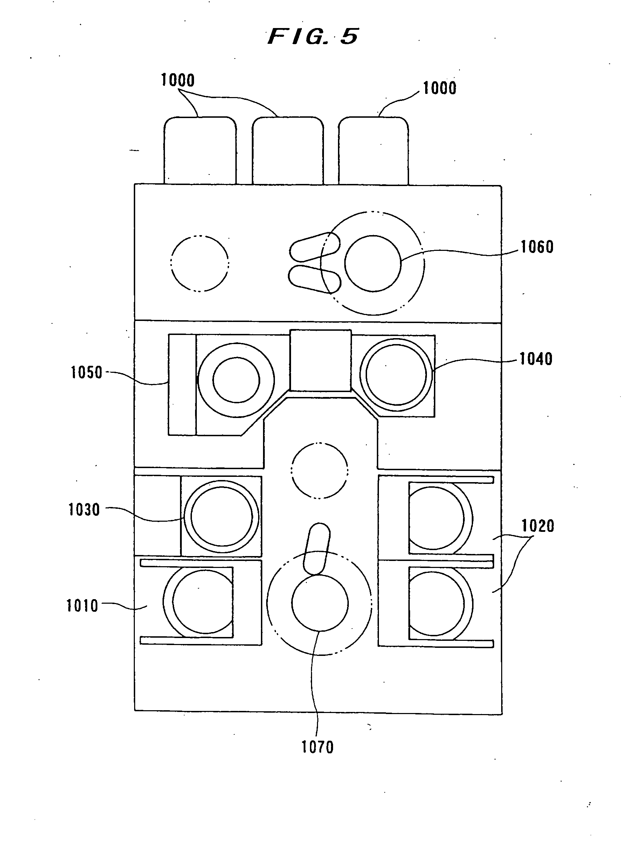

FIG. 5 is a layout plan of an apparatus for forming fine circuit interconnects according to still another embodiment of the present invention. The apparatus includes loading/unloading sections 1000, a bevel-etching/chemical cleaning section 1050, a cleaning/drying section (spin-rinsing/drying unit) 1040, one first plating section 1010 for carrying out a first-step plating (copper alloy plating), two second plating sections 1020 for carrying out a second-step plating (filling with copper by copper plating), and a cleaning section 1030 for cleaning a substrate between the first-step plating and the second-step plating. The apparatus is also provided with a first transfer mechanism 1060 for transferring a substrate between the loading/unloading sections 1000, the bevel-etching/chemical cleaning section 1050 and the cleaning/drying section 1040, and a movable second transfer mechanism 1070 for transferring the substrate between the bevel-etching/chemical cleaning section 1050, the cleaning/drying section 1040, the first plating section 1010, the second plating sections 1020 and the cleaning section 1030.

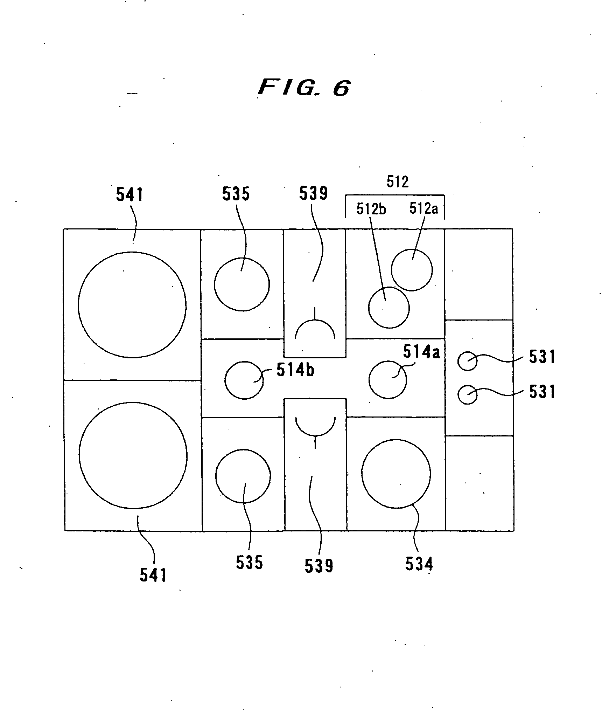

FIG. 6 is a layout plan of an apparatus for forming fine circuit interconnects according to still another embodiment of the present invention, in which polishing sections are incorporated so that polishing of the surface of a substrate can be carried out immediately after plating. The apparatus comprises substrate cassettes 531, 531 for loading/unloading a substrate, a plating section 512, cleaning sections 535, 535 for cleaning the substrate, two transfer mechanisms 514a, 514b, reversing machines 539, 539, polishing sections 541, 541, and a spin-dryer 534. The plating section 512 includes a copper alloy plating bath 512a for forming the first plated film 6 (see FIG. 1D) and a copper plating bath 512b for forming the second plated film 7 (see FIG. 1E).

The flow of a substrate in the apparatus described above is as follows: First, the transfer mechanism 514a takes a substrate out of one cassette 531 for loading and transfers the substrate to the plating section 512. In the plating section 512, the substrate is plated in the copper alloy plating bath 512a and then in the copper plating bath 512b. Thereafter, the transfer mechanism 514a transfers the substrate to either one of the reversing machines 539 where the substrate is reversed so that the plated surface faces downward, and the substrate is received by the other transfer mechanism 514b. The transfer mechanism 514b transfers the substrate to either one of the polishing sections 541 to carry out intended polishing of the substrate. The polished substrate is taken out by the transfer mechanism 514b and transferred to either one of the cleaning sections 535 to clean the substrate. The cleaned substrate is then transferred to the other polishing section 541, where the substrate is re-polished. Thereafter, the substrate is transferred by the transfer mechanism 514b to the other cleaning section 535 to clean the substrate. The substrate after cleaning is transferred by the transfer mechanism 514b to the other reversing machine 539, where the substrate is reversed so that the processed surface faces upward, and the substrate is then transferred by the transfer mechanism 514a to the spin-drier 534 to spin-dry the substrate. Thereafter, the substrate is placed by the transfer mechanism 514a in the cassette 531 for unloading.

The present invention will now be described in greater detail by way of the following non-limiting Examples.

### Example 1

Using a copper alloy plating solution containing 14.4 g/L of copper pyrophosphate, 0.05 g/L of tin pyrophosphate and 94 g/L of pyrophosphoric acid, whose pH was adjusted to 9.5 with tetramethylammonium hydroxide (TMAH), as a plating solution for forming a first plated film on a seed layer of a substrate, first-step plating was carried out at a current density of 0.5 A/dm² for 20 seconds. Thereafter, using a copper sulfate plating solution containing 225 g/L of copper sulfate, 55 g/L of sulfuric acid, 60 mg/L of chlorine and 5 mL/L of organic additive, second-step plating (filling with copper) was carried out at a current density of 2.5 A/dm² for two minutes. The film (first plated film) formed by the first-step plating was a copper alloy film containing 1 % by weight of tin. SEM observation revealed no formation of voids in all of the via holes of the substrate. The plated copper layer had superior electromigration endurance as compared to the case of not forming the first plated film.

### Example 2

Using an electroless copper alloy plating solution containing 15 g/L of copper sulfate, 1 g/L of tin sulfate, 50 g/L of EDTA and 25 g/L of glyoxylic acid (GOA) , whose pH was adjusted to 10.5 with TMAH, as a plating solution for forming a first plated film on a catalyst layer of a substrate, first-step plating was carried out at 60°C for 60 seconds. Thereafter, using the same copper sulfate plating solution as used in Example 1, second-step plating was carried out under the same plating conditions as in Example 1. The film (first plated film) formed by the first-step plating was a copper alloy film containing 1.3 % by weight of tin. SEM observation revealed no formation of voids in all of the via holes of the substrate. The plated copper layer had superior electromigration endurance as compared to the case of not forming the first plated film.

### Example 3

Using a copper alloy plating solution containing 5 g/L of copper acetate, 40 g/L of ammonium acetate, 10 g/L of nickel sulfate and 60 g/L of EDTA, whose pH was adjusted to 12 with ethylenediamine, as a plating solution for forming a first plated film on a seed layer of a substrate, first-step plating was carried out at a current density of 0.5 A/dm² for 20 seconds. Thereafter, using a copper sulfate plating solution containing 180 g/L of copper sulfate, 25 g/L of sulfuric acid, 40 mg/L of chlorine and 5 mL/L of organic additive, second-step plating (filling with copper) was carried out at a current density of 2.5 A/dm² for 2 minutes. The film (first plated film) formed by the first-step plating was a copper alloy film containing 0.8 % by weight of nickel. SEM observation revealed no formation of voids in all of the via holes of the substrate. The plated copper layer had superior electromigration endurance as compared to the case of not forming the first plated film.

As described hereinabove, according to the method of the present invention, migration in the circuit formed by copper can be suppressed or retarded whereby defect of the copper circuit is less likely to occur. This enables production of finer circuits, leading to speed-up and densification of circuits or semiconductors.

Further, the present method, which merely involves the additional step of copper alloy plating before the conventional acidic copper plating, such as copper sulfate plating, which is generally employed for the formation of circuits, does not necessitate a considerable change of facilities or provision of a special device. In addition, the present method can enjoy the merits of the copper sulfate plating or the like, such as excellent embedding properties, low resistivity of the plated film and low cost.

Furthermore, by properly selecting the type and conditions of the plating bath, it becomes possible to provide a copper alloy film with a gradient alloy composition in which the alloy ratio changes stepwise or continuously from the bottom layer.

Although certain preferred embodiments of the present invention have been shown and described in detail, it should be understood that various changes and modifications may be made therein without departing from the scope of the appended claims.

## Claims

1. A method for forming fine circuit interconnects, comprising:
providing a substrate for electronic circuit having fine circuit patterns which are covered with a barrier layer and optionally a seed layer;
forming a first plated film on the surface of the substrate by copper alloy plating; and
forming a second plated film on the surface of the first plated film by copper plating.

2. The method according to claim 1, wherein the first plated film is one that prevents electromigration and/or stress-migration of copper.

3. The method according to claim 1, wherein the first plated film is deposited from an alloy plating solution containing copper and a metal which can form a eutectoid alloy with copper.

4. The method according to claim 3, wherein the metal which can form a eutectoid alloy with copper is selected from the group consisting of Fe, Co, Ni, Zn, Sn, In, Ga, Tl, Zr, W, Mo, Rh, Ru, Ir, Ag, Au and Bi.

5. The method according to claim 1, wherein the content of the metal other than copper in the first plated film is 0.01 to 10 atomic %.

6. The method according to claim 1, wherein the resistivity of the first plated film is not more than 5 µΩ·cm in terms of volume resistivity.

7. The method according to claim 1, wherein the first plated film is formed by electroplating.

8. The method according to claim 1, wherein the first plated film is formed by electroless plating.

9. The method according to claim 1, wherein the first plated film has a thickness of 1 nm to 200 nm.

10. The method according to claim 1, wherein the second plated film formed by copper plating is one for embedding of fine trenches and/or via holes provided in the substrate.

11. The method according to claim 1, wherein the second plated film is formed in a copper plating bath containing sulfuric acid, or an alkane or alkanol sulfonic acid.

12. The method according to claim 1, wherein the second plated film is formed in a copper plating bath containing pyrophosphoric acid.

13. The method according to claim 1, further comprising the process of annealing the substrate after the formation of the second plated film.

14. The method according to claim 13, wherein the annealing is carried out at 100 to 500 °C.

15. An apparatus for forming fine circuit interconnects, comprising:
a copper alloy plating section for forming a first plated film on the surface of a substrate by copper alloy plating;
a copper plating section for forming a second plated film on the surface of the first plated film by copper plating;
a cleaning section for cleaning the substrate; and
a carry-in and carry-out section for carrying in and out the substrate.

16. The apparatus according to claim 15, further comprising an annealing section for annealing the substrate after the formation of the second plated film.

17. The apparatus according to claim 15, wherein the first plated film is one that prevents electromigration and/or stress-migration of copper.

18. The apparatus according to claim 15, wherein the first plated film is deposited from an alloy plating solution containing copper and a metal which can form a eutectoid alloy with copper.

19. The apparatus according to claim 18, wherein the metal which can form a eutectoid alloy with copper is selected from the group consisting of Fe, Co. Ni, Zn, Sn, In, Ga, Tl, Zr, W, Mo, Rh, Ru, Ir, Ag, Au and Bi.

20. The apparatus according to claim 15, wherein the copper alloy plating section comprises an electroplating device.

21. The apparatus according to claim 15, wherein the copper alloy plating section comprises an electroless plating device.
